Europäisches Patentamt

European Patent Office

Office européen des brevets

(19)

(11) Publication number: **0 439 324 A2**

(12) **EUROPEAN PATENT APPLICATION**

(21) Application number: 91300468.5

(22) Date of filing: 22.01.91

(51) Int. Cl.⁵: **G03F 7/00**

(30) Priority: 23.01.90 JP 11909/90

(43) Date of publication of application:
31.07.91 Bulletin 91/31

(84) Designated Contracting States:
DE FR GB NL

(71) Applicant: Oki Electric Industry Company,
Limited
7-12, Toranomon 1-chome Minato-ku
Tokyo 105 (JP)

(72) Inventor: Tsubota, Takashi, c/o Oki Electric
Ind. Co. Ltd.
7-12, Toranomon 1-chome
Minato-ku, Tokyo (JP)
Inventor: Hosoi, Yoji, c/o Oki Electric Ind. Co.
Ltd.
7-12, Toranomon 1-chome
Minato-ku, Tokyo (JP)

(74) Representative: Read, Matthew Charles et al
Venner Shipley & Co. 368 City Road
London EC1V 2QA (GB)

(54) **Process of forming diffraction grating without using a separation film between positive and negative resists.**

(57) A process of forming a diffraction grating on a semiconductor substrate (21). The diffraction grating has a phase inversion area (26) at the center thereof. The process has the steps of coating a photoresist film (22) (which has a characteristic that light-sensitivity thereof reverses depending on an exposure time period) on the semiconductor substrate (21), dividing the photoresist film (22) by a first exposure into an unexposed area (24) and an exposed area (23) in which the light-sensitivity thereof is reversed, exposing and developing the photoresist film (22) which has been divided into the unexposed (24) and exposed (23) areas by a second exposure, thereby to form a diffraction grating pattern (25) that includes the phase inversion area (26), transferring the diffraction grating pattern (25) formed on the photoresist film (22) to the substrate (21), and removing the photoresist film (22) from the substrate (21). The diffraction grating having the phase inversion area (26) can be formed by using the same, one resist (the second resist). The separation film, which was required in a conventional technique between the positive and negative resists, can be obviated.

# Fig. 2A

EP 0 439 324 A2

# Fig. 2D

21

# PROCESS OF FORMING DIFFRACTION GRATING WITHOUT USING A SEPARATION FILM BETWEEN POSITIVE AND NEGATIVE RESISTS

## BACKGROUND OF THE INVENTION

### Field of the Invention

The present invention relates to a process of forming a diffraction grating on which periodic parallel grooves are formed by using two-beam interference exposure process, and particularly to a process for forming a diffraction grating including a phase inversion area therein.

### Description of the Prior Art

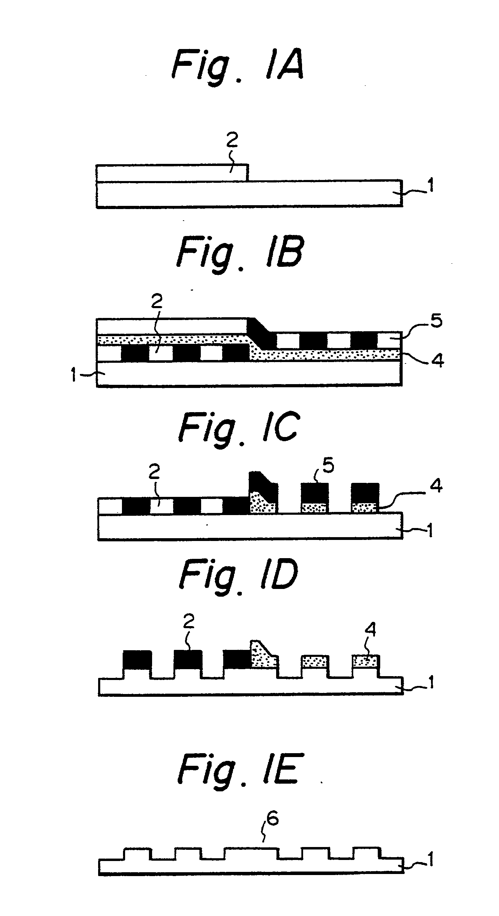

As a typical process for forming this kind of diffraction grating, is known a reference on page 202 of the Extended Abstract of the 46-th Autumn Meeting, 1985, of the Japanese Society of Applied Physics. This process for forming the diffraction grating will be reviewed below with reference to FIGS. 1A - 1E.

First, a novolak-based positive resist 2 (e.g. Micro-Posit) is coated on a InP substrate 1, and then strips of the positive resist 2 of a certain breadth are formed thereon by using a photolithography method or the like, see FIG. 1A.

Next, a SiN film 4 is formed on the substrate 1 and positive resist 2 by using an electron cyclotron resonance (ECR) method, one of the PCVD method. After that, a negative resist such as MRL 5 is coated on the SiN film 4 which has been formed for the purpose of separating the positive resist 2 and the negative resist 5. Subsequently, the negative and positive resists 2 and 5 are exposed by the two-beam interference exposure method, see FIG. 1B.

Then, the negative resist 5 is developed. In this process, that portion of the negative resist 5 on the positive resist 2 is positioned at nodes of the standing waves generated between the surface of the substrate 1 and the negative resist 5, so that the exposure of that portion is insufficient, causing that portion to be removed in its entirety. After that, the SiN film 4 is etched by hydrofluoric acid using the negative resist 5 as a mask. Thus, a pattern as shown in FIG. 1C is formed.

Next, the positive resist 2 is subjected to a development process, and then a diffraction grating is transferred on the substrate 1 by hydrogen bromide-based etchant using the pattern formed by the positive resist 2 and SiN film 4 as a mask, see FIG. 1D.

Finally, the positive resist 2 and SiN film 4 are removed. Thus, the diffraction grating is completed, see FIG. 1E. In this process, a phase inversion area 6 is formed at the boundary portion between the positive resist 2 and the SiN film 4.

In the conventional process for forming the diffraction grating, however, the optical standing wave effect is used to prevent the negative resist 5, which is coated on the positive resist 2, from being exposed. This requires not only strict thickness control on the resists 2 and 5 but also on the SiN film 4 because the SiN film 4 is intervenes between the positive and negative resists 2 and 5 as a separation film for preventing contact between both of the resists. This presents problems that the processing time increases and the yield decreases.

Furthermore, since a partial joint between the positive and negative resists 2 and 5 is unavoidable at the phase inversion area 6, a transition area occurs at that part. This poses a problem that the joint portion of the two resists causes distortion on the phase inversion area 6.

## SUMMARY OF THE INVENTION

It is therefore an object of the present invention to provide a process of forming a diffraction grating which is superior in process control with an increased yield, and minimized in distortion in the phase inversion area.

To accomplish the object, the present invention is provided with a process of forming a diffraction grating on a semiconductor substrate, the diffraction grating having a phase inversion area in the center of the grating, the process comprising the steps of : coating a photoresist film on the semiconductor substrate, the photoresist film having a characteristic that light-sensitivity thereof reverses depending on an exposure period of time ; separating the photoresist film by a first exposure into an unexposed area and an exposed area in which the light-sensitivity thereof is reversed ; exposing and developing the photoresist film, which has been divided into the unexposed area and the exposed area, by a second exposure, thereby to form a diffraction grating pattern that includes the phase inversion area ; transferring the diffraction grating pattern formed on the photoresist film to the substrate ; and removing the photoresist film from the substrate.

The present invention divides the photoresist film by the first exposure into the unexposed area and the exposed area in which the light-sensitivity is reversed by the exposure, and then, the diffractive grating pattern is formed by the second exposure and the development. As a result, the diffraction grating having the phase inversion area can be formed by using the same, one resist. Accordingly, the separation film between the positive and negative resists can be obviated.

## BRIEF DESCRIPTION OF THE DRAWINGS

The objects and features of the present invention will become more apparent from the consideration of the following detailed description taken in conjunction with the accompanying drawings in which :

FIGS. 1A - 1E are cross-selectional views showing the steps of a diffraction grating manufactured in a conventional process ; and

FIGS. 2A - 2D are cross-selectional views, similar to FIGS. 1A - 1E, showing the steps of a diffraction grating formed by a process of an embodiment of the present invention.

## DESCRIPTION OF THE PREFERRED EMBODIMENT

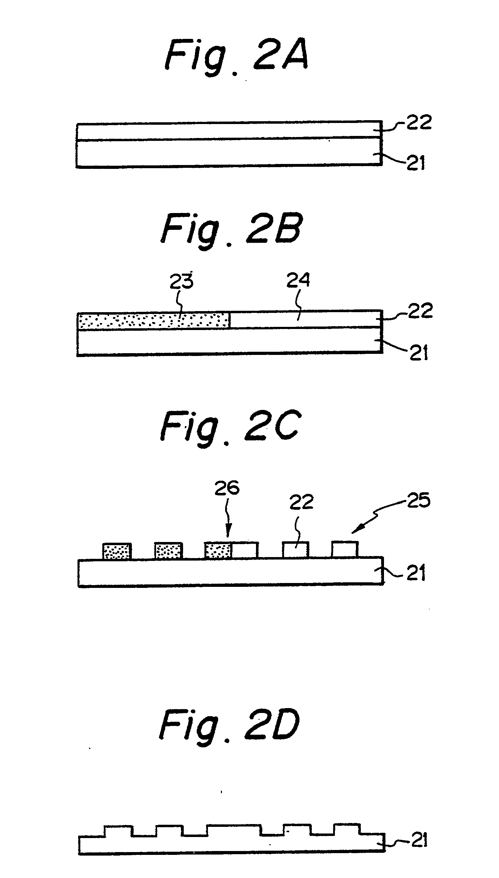

An embodiment of a process of forming a diffraction grating of the present invention will now be described with reference to FIGS. 2A - 2D. First, on an InP substrate 21, is stuck an LB (Langmuir-Blodgett) film 22 that changes its light-sensitivity from negative to positive depending on an exposure period of time, see FIG. 2A. More specifically, the InP substrate 21 is soaked in a container in which an organic compound, such as 12-8-pentacosa-di-onyxsan acid for forming the LB film, is floating, and is pulled up so that the LB film 22 is formed on the substrate 21 as shown in FIG. 2A.

Next, an exposed area 23 and an unexposed area 24 are formed by the photolithography : the exposed area 23 becomes a positive resist by being radiated by UV light, while the unexposed area 24 is maintained as a negative resist (see FIG. 2B) because this part is not radiated.

Subsequently, the exposed area 23 and the unexposed area 24 are subjected to the two-beam interference exposure, and then to the development. Thus, a diffraction grating pattern 25 is formed, in which rulings are uniformly spaced about 0.1 micron apart, and a phase inversion area 26 is positioned substantially at the center of the diffraction grating 25, in the illustrative embodiment, see FIG. 2C.

After that, the total structure including substrate 21 undergoes etching by using the hydrogen bromide as an etchant with the diffraction grating pattern 25 of LB film 22 used as a mask. Thus, the diffraction grating pattern 25 is transferred to the substrate 21. Finally, the LB film 2s is removed so that the diffraction grating is completed, see FIG. 2D.

While the present invention has been described with reference to the particular illustrative embodiment, it is not to be restricted by this embodiment but only by the appended claims. It is to be appreciated that those skilled in the art can change or modify the embodiment without departing from the scope and spirit of the present invention.

## Claims

1. A process of forming a diffraction grating on a semiconductor substrate (21), said diffraction grating (21) having a phase inversion area (26) in the center of the grating,

   CHARACTERIZED IN THAT

   said process comprises the steps of :

   coating a photoresist film (22) on the semiconductor substrate (21), said photoresist film (22) having a characteristic that light-sensitivity thereof reverses depending on an exposure period of time ;

   separating said photoresist film (22), by a first exposure, into an unexposed area (24), and an exposed area (23) in which the light-sensitivity thereof is reversed ;

   exposing and developing said photoresist film (22), which has been divided into said unexposed area (24) and said exposed area (23), by a second exposure, thereby to form a diffraction grating pattern (25) that includes the phase inversion area (26) ;

   transferring said diffraction grating pattern (25) formed on said photoresist film (22) to said substrate (21) ; and

   removing said photoresist film (22) from said substrate (21).

2. A process of forming a diffraction grating according to claim 1, CHARACTERIZED IN THAT said photoresist film (22) is a Langmuir-Blodgett film.

3. A process of forming a diffraction grating according to claim 1, CHARACTERIZED IN THAT said first exposure is accomplished by a photolithography.

4. A process of forming a diffraction grating according to claim 1, CHARACTERIZED IN THAT said second exposure is a two-beam interference exposure.

Fig. IA

Fig. IB

Fig. IC

Fig. ID

Fig. IE

# Fig. 2A

22

21

# Fig. 2B

23    24

22

21

# Fig. 2C

26    22    25

21

# Fig. 2D

21